# EUROPÄISCHE PATENTSCHRIFT

(11) **EP 0 609 665 B1**
(45) Veröffentlichungstag und Bekanntmachung des Hinweises auf die Patenterteilung: **22.09.1999**
(21) Anmeldenummer: 94100338.6
(22) Anmeldetag: 12.01.1994
(51) Int. Cl.: H03G 5/00

(54) **Schaltungsanordnung zur digitalen Verarbeitung von Audiosignalen**
Circuit for digital processing of audio signals
Circuit pour le traitement numérique de signaux audio

(30) Priorität: 05.02.1993 DE 4303386
(43) Veröffentlichungstag der Anmeldung: 10.08.1994
(73) Patentinhaber: Blaupunkt-Werke GmbH, D-31139 Hildesheim (DE)
(72) Erfinder: Vogt, Lothar Dr., D-31249 Hohenhameln (DE); Herrmann, Matthias, DE-31141 Hildesheim (DE)

(56) Entgegenhaltungen:
- WO-A-93/02503
- PATENT ABSTRACTS OF JAPAN vol. 13, no. 150 (E-742) 12. April 1989 & JP-A-63 309 011 (MATSUSHITA ELECTRIC)
- PATENT ABSTRACTS OF JAPAN vol. 12, no. 189 (E-616) 2. Juni 1988 & JP-A-62 292 009 (FUJITSU TEN)
- ICASSP 86 PRODEEDINGS, Bd.3 OF 4, April 1986, IEEE NEW YORK US Seiten 29.6.1 - 29.6.4, XP12569 J. VAN GINDERDEUREN ET AL. 'Application Specific Integrated Filters for HiFi Digital Audio Signals'

## Beschreibung

Die Erfindung geht aus von einer Schaltungsanordnung nach der Gattung des Hauptanspruchs.

Für Rundfunkempfänger sind Schaltungen zur Verarbeitung von Audiosignalen bekannt, die eine Klangeinstellung, insbesondere des Frequenzgangs für hohe und tiefe Frequenzen, eine Lautstärkeeinstellung und im Falle von Stereo-Wiedergabe eine Balanceeinstellung ermöglichen. Ferner ist bei der Wiedergabe über mehr als zwei Lautsprecher eine Einstellung des Lautstärkeverhältnisses zwischen den einzelnen Lautsprechergruppen bekannt - in einem Auto beispielsweise zwischen den vorderen und den hinteren Lautsprechern. Die Verwendung von digitalen Schaltungen für diese Aufgaben hat verschiedene Vorteile, wie beispielsweise eine gute Reproduzierbarkeit der Einstellungen, eine leichte Realisierbarkeit mit integrierten Schaltungen und der Fortfall jeglicher Abgleicharbeiten wegen Streuungen bei der Herstellung.

Bei der Verarbeitung von digitalen Audiosignalen ist die Zahl der Quantisierungsstufen eine wesentliche Größe. Häufig erfolgt eine Quantisierung der Audiosignale bei der Analog/Digital-Wandlung mit 16 Bit, was in Hinblick auf ein möglichst niedriges Quantisierungsrauschen auch bei einer hohen Dynamik von Musikdarbietungen an sich als ausreichend empfunden wird. Dieses trifft jedoch nur zu, wenn der zu quantisierende Amplitudenbereich voll ausgenutzt wird.

Aus der Druckschrift WO-A-93/02503 ist ein adaptiver Equalizer, das heißt, eine Schaltung zur Beeinflußung des Frequenzganges von Audiosignalen in einer Audioeinrichtung bekannt, bei dem ein digitales Audiosignal ein digitales Filter zur Beeinflußung seines Frequenzganges und nach Digital/Analog-Wandlung einen Leistungsverstärker zur Wiedergabe des Audiosignals durchläuft. Über zuführbare Stellgrößen sind dabei die Parameter des digitalen Filters, wie Mittenfrequenz und Bandbreite der beeinflußbaren Frequenzbänder und die Verstärkungsfaktoren für die einzelnen Frequenzbänder sowie der Verstärkungsfaktor für den nachgeschalteten Leistungsverstärker beeinflußbar. Die Stellgrößen zur Beeinflußung der genannten Parameter werden dabei in Abhängigkeit einer jeweils gewählten Signalquelle beeinflußt, so daß beispielsweise die Mittenfrequenzen der beeinflußbaren Frequenzbereiche des digitalen Filters automatisch an die Bandbreite des Audiosignals angepaßt wird, die beispielsweise für nach dem US-Standard übertragene FM- und AM-Rundfunksignale unterschiedliche Werte aufweist.

Des weiteren ist aus JP-A-63-309011 ein digitaler graphischer Equalizer bekannt, welcher in einem invariabel konstanten dynamischen Bereich arbeitet. Der Amplitudenpegel der Eingangsfrequenzcharakteristik wird detektiert und dementsprechend die Verstärkung des Ausgangssignales gesteuert, wobei ein Filterkoeffizient so gesetzt wird, daß sein arithmetischer Fehler ein Minimum ist.

Aufgabe der vorliegenden Erfindung ist es, eine Schaltungsanordnung zur digitalen Verarbeitung von Audiosignalen nach der Gattung des Hauptanspruchs vorzuschlagen, die trotz verschiedener Eingriffe in die Übertragungscharakteristik für die Audiosignale den für eine Quantisierung zur Verfügung stehenden Amplitudenbereich möglichst voll ausnutzt.

Die erfindungsgemäße Schaltungsanordnung mit den Merkmalen des Hauptanspruchs eignet sich insbesondere zur Realisierung mit Hilfe einer integrierten Schaltung, der die Audiosignale in digitaler Form, beispielsweise mit einer Breite von 16 Bit zugeführt werden.

Ein Merkmal der Erfindung besteht darin, daß zur Bildung der Koeffizienten des digitalen Filters weitere Stellgrößen zuführbar sind, welche den Verlauf des Frequenzgangs bei hohen und bei tiefen Frequenzen gegenüber mittleren Frequenzen steuern, wobei im Falle eines Anhebens der hohen und/oder tiefen Frequenzen das Übertragungsmaß des Filters bei mittleren Frequenzen entsprechend abgesenkt wird, und daß eine die Absenkung kennzeichnende Stellgröße dem Lautstärkesteller zur Kompensation der Absenkung zuführbar ist.

Dadurch wird der zur Quantisierung zur Verfügung stehende Amplitudenbereich derart ausgenutzt, daß beim Anheben der hohen oder der tiefen Frequenzen keine Verzerrungen durch Überschreitung des Amplitudenbereichs entstehen, ohne daß bei Einstellungen ohne Anhebung der hohen oder tiefen Frequenzen eine Reserve berücksichtigt werden muß.

Durch die gleichzeitige Anwendung aller der obengenannten die Lautstärke der einzelnen Lautsprecher betreffenden Einstellungen ergeben sich erhebliche Pegelunterschiede, so daß von dem vorgegebenen Amplitudenbereich im ungünstigsten Fall nur ein kleiner Teil für die Quantisierung des Audiosignals zur Verfügung steht. Um auch bei großen Einstellbereichen das Auftreten von Quantisierungsrauschen zu verhindern, ist bei einer anderen Ausführungsform der Erfindung vorgesehen, daß der Lautstärkesteller mindestens ein Stellglied für digitale Signale, an das sich ein Digital/Analog-Wandler anschließt, und mindestens ein Stellglied für analoge Audiosignale aufweist und daß den Stellgliedern Stellgrößen derart zugeführt werden, daß das Stellglied für digitale Audiosignale möglichst bei einem maximalen Übertragungsmaß betrieben wird.

Eine Weiterbildung dieser Erfindung besteht darin, daß die Stellglieder eine exponentielle Charakteristik zwischen dem Übertragungsmaß und dem Zahlenwert der zugeführten Stellgröße aufweisen und daß die Überlagerung der Stellgrößen durch Addition erfolgt. Hierdurch vereinfachen sich die Schaltungen zur Überlagerung der einzelnen Stellgrößen ganz erheblich.

Durch die in weiteren Unteransprüchen aufgeführten Maßnahmen sind weitere vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild einer erfindungsgemäßen Schaltungsanordnung,
- Fig. 2: ein Blockschaltbild einer Anordnung zur Berechnung von Filter-Koeffizienten bei der Schaltungsanordnung nach Fig. 1,
- Fig. 3: ein steuerbares Filter als Klangsteller,
- Fig. 4: ein Blockschaltbild einer Schaltung zur Verarbeitung von Stellgrößen für die Lautstärkeeinstellung,
- Fig. 5: eine weitere Schaltung zur Verarbeitung der mit der Schaltung nach Fig. 4 verarbeitenden Stellgrößen,
- Fig. 6: ein Blockschaltbild des Lautstärkestellers,
- Fig. 7: Tabellen der Stellgrößen, die der erfindungsgemäßen Schaltungsanordnung zur Lautstärkeeinstellung zuführbar sind,
- Fig. 8: Tabellen der Stellgrößen, die der erfindungsgemäßen Schaltungsanordnung zur Klangeinstellung zuführbar sind,
- Fig. 9: eine Tabelle über die Zuordnung eines Signals zur Lautstärkeeinstellung innerhalb der erfindungsgemäßen Schaltungsanordnung zu einem Übertragungsmaß für die Audiosignale und
- Fig. 10: eine Tabelle über die Zuordnung zwischen einer weiteren internen Stellgröße zu einem weiteren Übertragungsmaß für die Audiosignale.

Gleiche Teile sind in den Figuren mit gleichen Bezugszeichen versehen. Das Ausführungsbeispiel sowie Teile davon sind zwar als Blockschaltbilder dargestellt. Dieses bedeutet jedoch nicht, daß die erfindungsgemäße Schaltungsanordnung auf eine Realisierung mit Hilfe von einzelnen den Blöcken entsprechenden Schaltungen beschränkt ist. Die erfindungsgemäße Schaltungsanordnung ist vielmehr in besonders vorteilhafter Weise mit Hilfe von hochintegrierten Schaltungen realisierbar. Dabei können digitale Signalprozessoren eingesetzt werden, welche bei geeigneter Programmierung die in den Blockschaltbildern dargestellten Verarbeitungsschritte durchführen. Die erfindungsgemäße Schaltungsanordnung kann zusammen mit weiteren Schaltungsanordnungen innerhalb einer integrierten Schaltung wesentliche Teile eines Rundfunkempfängers bilden.

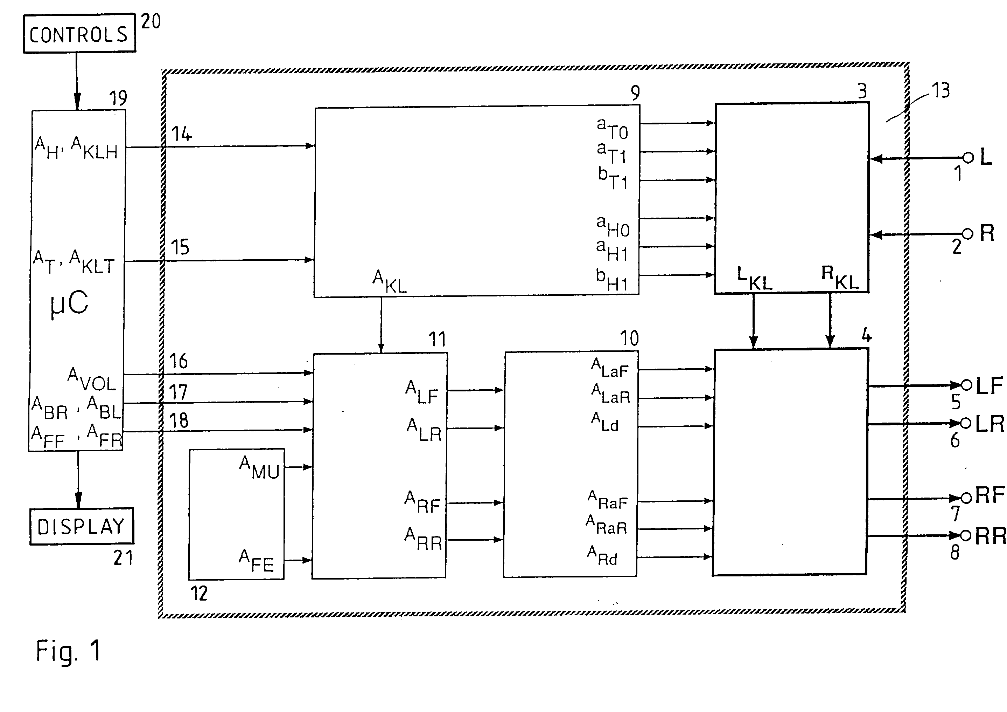

Eingängen 1, 2 der Schaltungsanordnung nach Fig. 1 sind digitale Audiosignale L und R vorzugsweise von einem Stereo-Decoder eines Rundfunkempfängers zuführbar. Über einen digitalen Klangsteller 3 werden die Audiosignale als Signale L_{KL} und R_{KL} einem Lautstärkesteller 4 zugeführt, der über vier Ausgänge 5, 6, 7, 8 verfügt, an denen jeweils ein Audiosignal LF, LR, RF und RR ansteht. Diese können über geeignete Endstufen jeweils einem Lautsprecher zugeführt werden. Jeweils für den linken und rechten Kanal sind zwei Lautsprecher vorgesehen, die beispielsweise in einem Auto vorn und hinten angeordnet sind.

Der Klangsteller 3 und der Lautstärkesteller 4 bilden zusammen mit Schaltungen 9, 10, 11 und 12, welche der Ableitung verschiedener Koeffizienten und Stellgrößen dienen, eine im folgenden Audioprozessor genannte Schaltungsanordnung 13. Über weitere Eingänge 14, 15, 16, 17, 18 werden dem Audioprozessor 13 von einem Mikrocomputer 19 verschiedene Stellgrößen zugeführt. Der Mikrocomputer 19 kann als sogenannter Geräte-Mikrocomputer ausgeführt sein, das heißt, weitere Funktionen innerhalb eines Gerätes, beispielsweise eines Rundfunkempfängers, steuern - wie beispielsweise die Senderabstimmung. An den Mikrocomputer 19 sind Bedienelemente 20 und Anzeigeeinrichtungen 21 angeschlossen.

Dem Audioprozessor 13 werden vom Mikrocomputer im einzelnen die in folgender Tabelle zusammengestellten Signale zugeführt. Eingang Zeichen Bedeutung

| | | |
|---|---|---|
| 14 | A_{H} | Anhebung bzw. Absenkung der Höhen |
| | A_{KLH} | Bewertungsfaktor für die Höheneinstellung |
| 15 | A_{T} | Anhebung bzw. Absenkung der Tiefen |
| | A_{KLT} | Bewertungsfaktor für die Tiefeneinstellung |
| 16 | A_{VOL} | Lautstärkeeinstellung |
| 17 | A_{BR} | Balance-Einstellung rechts |
| | A_{BL} | Balance-Einstellung links |
| 18 | A_{FF} | Dämpfung vorne |
| | A_{FR} | Dämpfung hinten. |

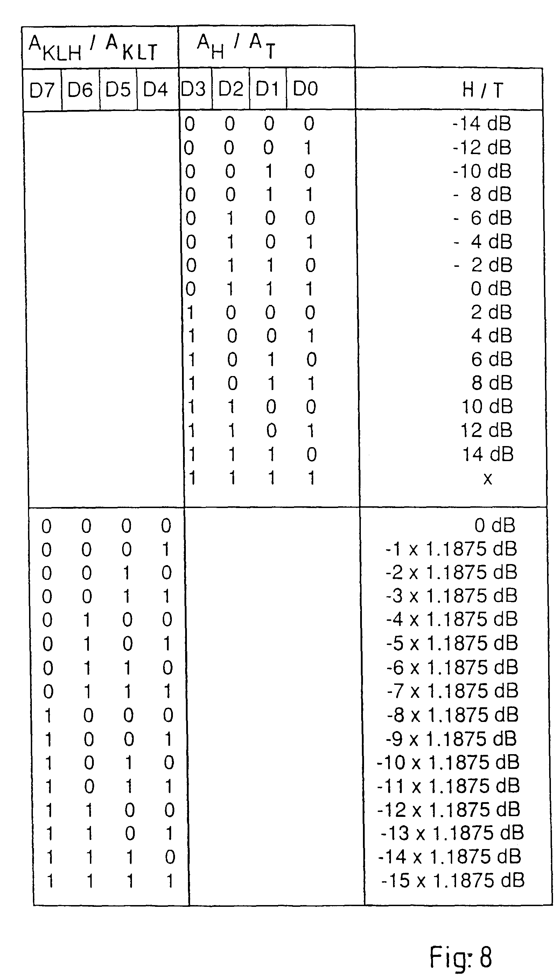

Die Zuordnung zwischen den Stellgrößen an den Eingängen 14 und 15 zu der jeweiligen Wirkung auf die Audiosignale ist in Fig. 8 als Tabelle dargestellt. Die Binärstellen D0 bis D3 dienen als Stellgrößen A_{T} bzw. A_{H} zur Anhebung bzw. Absenkung der Tiefen T bzw. der Höhen H zwischen -14 und +14 dB. Die Binärstellen D4 bis D7 bilden die Stellgrößen A_{KLT} bzw. A_{KLH} und bewirken jeweils eine Absenkung des Übertragungsmaßes des Klangstellers 3 für mittlere Frequenzen von 1,1875 dB pro Inkrement.

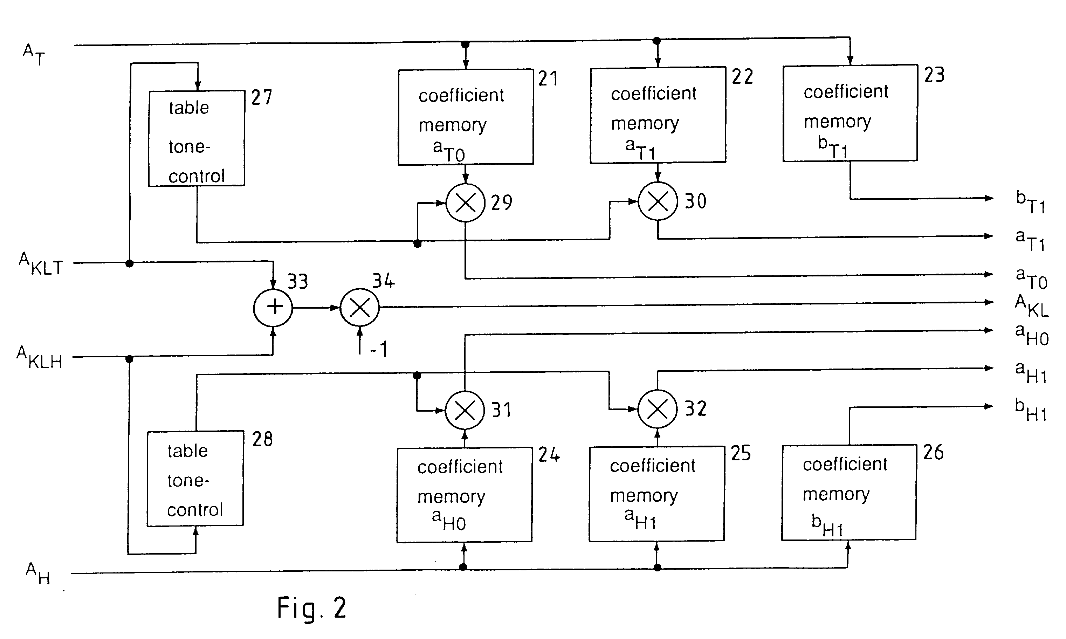

Aus den in den Eingängen 14, 15 zugeführten die Klangregelung betreffenden Stellgrößen werden in der in Fig. 2 dargestellten Schaltung 9 Koeffizienten für die Klangeinstellung ermittelt. Die Stellgrößen A_{T} und A_{H} enthalten Adressen, unter denen die jeweiligen Koeffizienten in Speichern abgelegt sind. Für die Tiefeneinstellung sind dieses die Speicher 21, 22, 23, für die Koeffizienten a_{T0}, a_{T1} und b_{T1}, für die Höheneinstellung die Speicher 24, 25, 26, für die Koeffizienten a_{H0}, a_{H1} und b_{H1}.

Außer den Adressen, welche von vier Binärstellen jeweils eines über die Eingänge 14, 15 (Fig. 1) zugeführten Datenwortes gebildet werden, stellen die Binärstellen D4 bis D7 eine Stellgröße A_{KLH} bzw. A_{KLT} dar, welche eine Pegelabsenkung der Audiosignale bewirkt, um eine Übersteuerung des Wertebereichs der digitalen Audiosignale bei Anheben der Höhen oder Tiefen zu vermeiden. Damit wird das Übertragungsmaß für die angehobenen Frequenzbereiche praktisch normiert. Die Signale A_{KLH} bzw. A_{KLT} werden einerseits je einem weiteren Speicher als Adresse zugeführt, wodurch jeweils ein Faktor für die Koeffizienten a_{T0}, a_{T1}, a_{H0} und a_{H1} erzeugt wird, mit dem die Koeffizienten bei 29, 30, 31, 32 multipliziert werden. Andererseits werden die Parameter A_{KLT} und A_{KLH} bei 33 addiert und bei 34 negiert. Das Ergebnis dient zur späteren Kompensation der durch die Normierung verursachten Signal-Dämpfung.

Von der in Fig. 2 dargestellten Schaltung werden die Koeffizienten dem Klangsteller 3 zugeführt, während die Größe A_{KL} zu der Schaltung 11 (Fig. 1) geleitet wird.

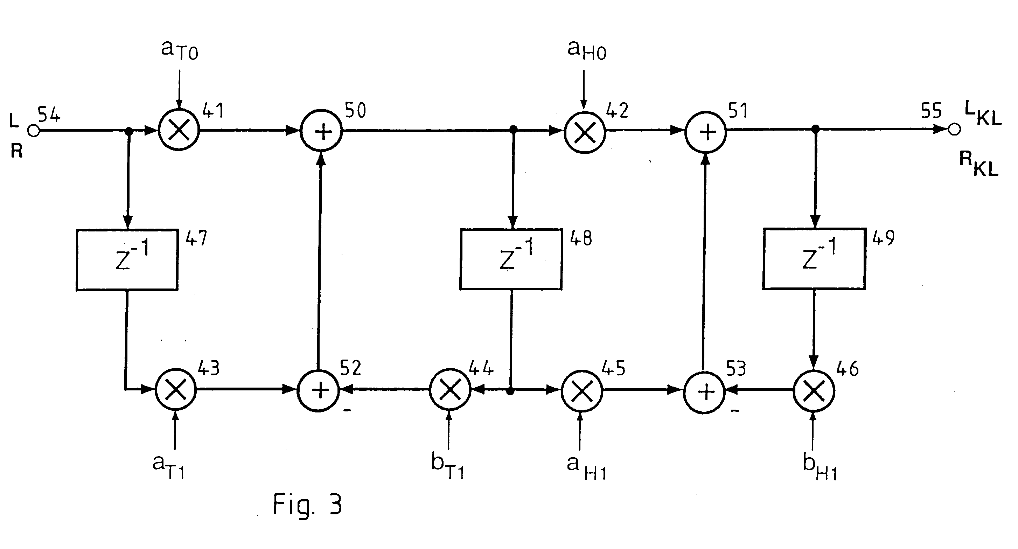

Der Klangsteller 3 wird im folgenden anhand von Fig. 3 näher erläutert, wobei lediglich einer von zweien für jeweils einen Kanal vorgesehener Klangsteller als Blockschaltbild dargestellt ist. Dieser weist eine rekursive Struktur auf mit sechs Multiplizierern 41, 42, 43, 44, 45, 46, drei Verzögerungselementen 47, 48, 49 und vier Addierern 50, 51, 52, 53. Die Höhen- und die Tiefeneinstellung erfolgen getrennt durch gleichzeitige Veränderung der jeweiligen Filter-Koeffizienten a_{T0}, a_{T1}, b_{T1} für die Tiefen und a_{H0}, a_{H1} und b_{H1} für die Höhen. Das jeweilige Audiosignal L bzw. R ist einem Eingang 54 zuführbar, das Ausgangssignal L_{KL} bzw. R_{KL} wird von einem Ausgang 55 dem Lautstärkesteller 4 (Fig. 1) zugeführt.

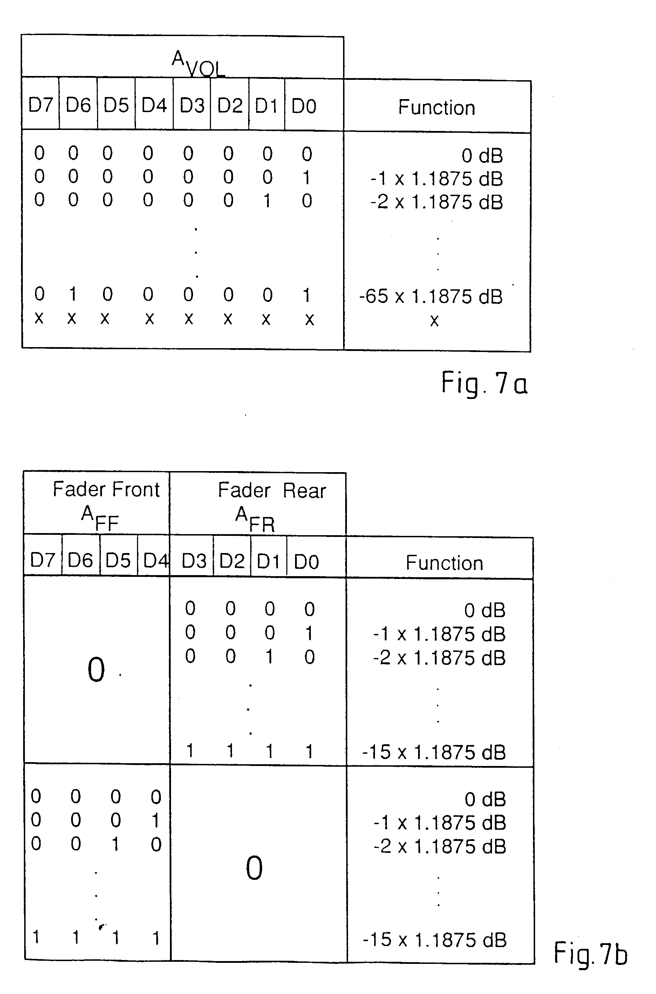

Die Stellgrößen A_{VOL} für die Lautstärke, A_{BR} und A_{BL} für die Balance und A_{FF} und A_{FR} für den Fader, das heißt, für das Lautstärkeverhältnis zwischen den vorderen und den hinteren Lautsprechern, beschreiben die Dämpfung gegenüber dem maximalen Übertragungsmaß des Lautstärkestellers 4. Der Wert 0 dieser Größen bedeutet also ein maximales Übertragungsmaß. Fig. 7a stellt in Tabellenform eine Zuordnung zwischen einzelnen Werten der Stellgröße A_{VOL} und der korrespondierenden Dämpfung dar. Mit jeweils einer Inkrementierung von A_{VOL} wird die Dämpfung um jeweils 1,1875 dB vergrößert. Der größte Wert, den A_{VOL} annehmen kann, ist 65.

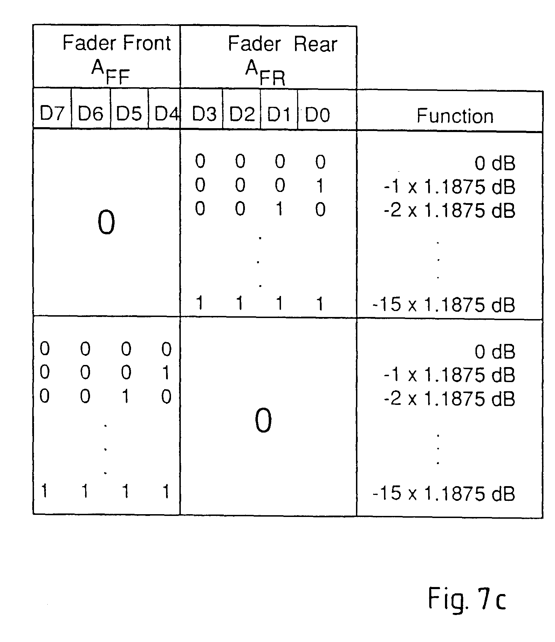

In ähnlicher Weise ist bei dem Ausführungsbeispiel die Zuordnung zwischen den Stellgrößen A_{BL} und A_{BR} und der Dämpfung festgelegt, was in Fig. 7b dargestellt ist. Da für die Balance-Einstellung ein geringerer Einstellbereich ausreichend ist, werden beide Stellgrößen gemeinsam mit einem Byte ausgegeben. In ähnlicher Weise enthält jeweils ein vom Mikrocomputer 19 (Fig. 1) ausgegebenes Datenwort die Stellgrößen A_{FF} und A_{FR}, deren Zuordnung zu den Dämpfungswerten in Fig. 7c dargestellt ist.

Die beschriebenen Stellgrößen werden in der Schaltung 11 zu vier Stellgrößen A_{LF}, A_{LR}, A_{RF} und A_{RR} kombiniert, welche jeweils die Dämpfung eines der Ausgänge 5 bis 8 bedeuten. Dabei werden zwei weitere Stellgrößen, nämlich A_{MU} und A_{FE} berücksichtigt, die in einer Schaltung 12 zur Wertung der Qualität des Signals gebildet werden. Die Stellgröße A_{MU} bedeutet eine zusätzliche 3 dB-Dämpfung bei gestörtem Empfang, während A_{FE} eine wesentlich stärkere Dämpfung bei gestörtem Empfang (Aufrauschdämpfung), nämlich 30 dB zur Folge hat.

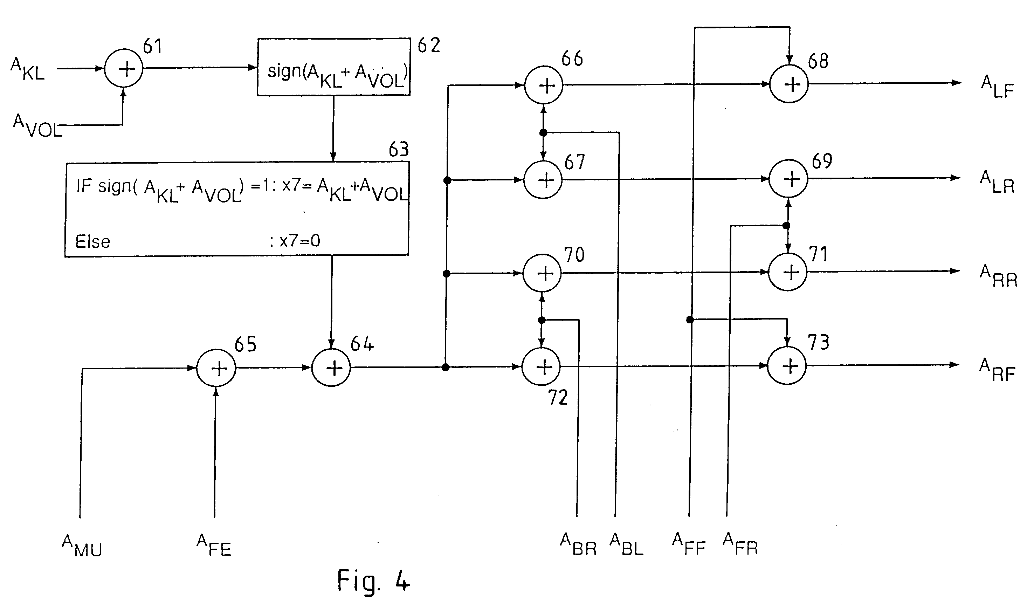

Wie die Stellgrößen in der Schaltung 11 kombiniert werden, ist in Form eines Blockschaltbildes in Fig. 4 dargestellt. Durch eine Addition des Parameters A_{KL} zur Stellgröße A_{VOL} wird die durch die Normierung im Zusammenhang mit der Klangeinstellung verursachte Signal-Dämpfung kompensiert. Dabei ist jedoch sicherzustellen, daß die weiter zu verarbeitende Summe nicht negativ wird. Dazu wird bei 62 das Vorzeichen der Summe aus A_{KL} und A_{VOL} festgestellt und bei 63 im Falle eines positiven Vorzeichens einem Addierer 64 die Summe und ansonsten der Wert 0 zugeführt.

Dem Addierer 64 werden über einem weiteren Addierer 65 außerdem die Dämpfungswerte A_{MU} und A_{FE} zugeleitet. Nach dem Addierer 64 erfolgt eine Aufteilung auf vier Kanäle zur Bildung der Dämpfungswerte für die vier Ausgangs-Audiokanäle. In jeweils einem Kanal sind zwei Addierschaltungen 66 bis 73 angeordnet. Von den Stellgrößen für die Balance wird A_{BR} den Addierschaltungen 70, 72 und A_{BL} den Addierschaltungen 66, 67 zugeführt, so daß jeweils die beiden linken und die beiden rechten Kanäle beeinflußt werden. Die Stellgrößen A_{FF} und A_{FR} werden den Addierschaltungen 68, 73 einerseits und den Addierschaltungen 69, 71 andererseits zugeleitet, so daß von einer Stellgröße jeweils beide vorderen oder beide hinteren Kanäle beeinflußbar sind.

Die Ausgangssignale der Schaltung 11 (Fig. 1, Fig. 4) werden einer Aufspaltungs-Schaltung 10 zugeleitet, welche die Stellgrößen für mehrere jeweils in einem Kanal des Lautstärkestellers angeordnete Stellglieder bildet, die Stellgrößen also "aufspaltet". Wie bereits eingangs erwähnt, ist ein Hauptvorteil der Erfindung, die zur Verfügung stehenden Quantisierungsstufen, vorzugsweise eine 16-Bit-Quantisierung, möglichst optimal auszunutzen. Das heißt, für das jeweils eingestellte Ausgangssignal soll eine möglichst hohe Anzahl von Quantisierungsstufen erhalten bleiben, auch wenn die zugeführten Stellgrößen eine hohe Dämpfung des Signals zur Folge haben. Es ist daher im Lautstärkesteller sowohl in der digitalen Ebene als auch in der analogen Ebene jeweils ein Dämpfungsstellglied vorgesehen.

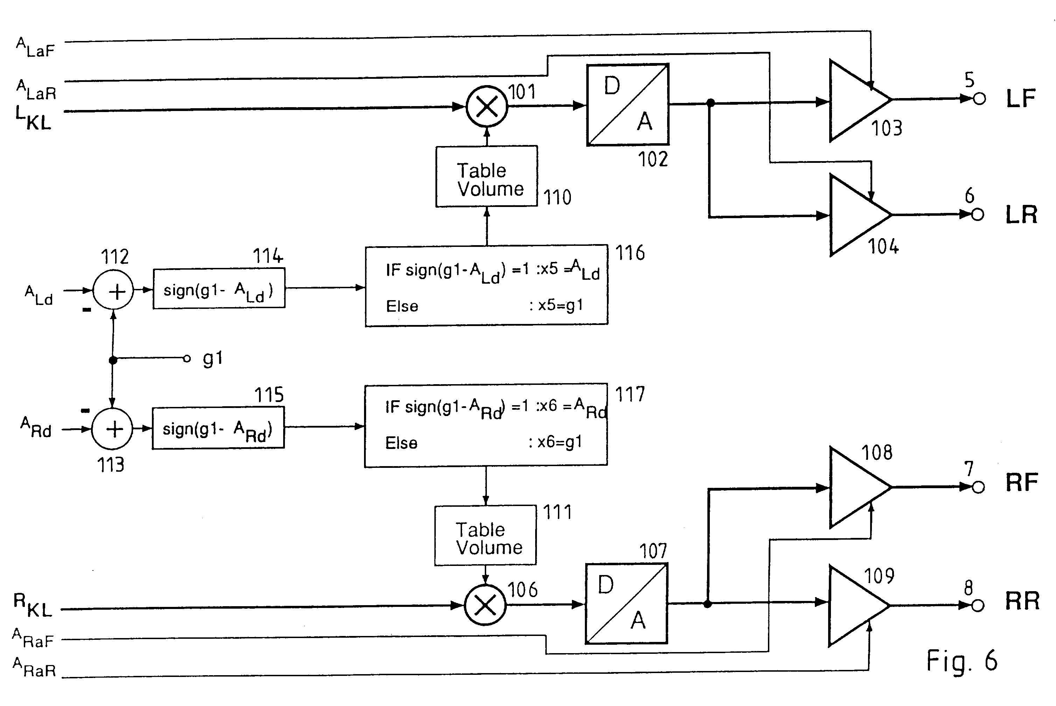

Wie später im Zusammenhang mit Fig. 6 genauer beschrieben wird, ist ein digitales Stellglied jeweils für den linken und rechten Kanal angeordnet, während je ein Stellglied für Analogsignale im linken vorderen, im rechten vorderen, im linken hinteren und im rechten hinteren Kanal vorgesehen ist. In der Aufspaltungs-Schaltung 10 werden daher aus den vier zugeführten Signalen zwei Signale A_{Ld} und A_{Rd} zur Steuerung der digitalen Dämpfungsstellglieder und vier Signale A_{LaF}, A_{LaR}, A_{RaR} und A_{RaF} zur Steuerung von analogen Dämpfungsstellgliedern abgeleitet. Die resultierenden Dämpfungen werden derart auf die obigen Ausgangsgrößen der Schaltung 10 verteilt, daß die analogen Stellglieder eine möglichst hohe Dämpfung bewirken und bei resultierenden Dämpfungen, die größer als die maximale Dämpfung der analogen Stellglieder sind, eine zusätzliche Dämpfung mit den digitalen Stellgliedern realisiert wird. Damit werden die Digital/Analog-Wandler bestmöglich ausgesteuert.

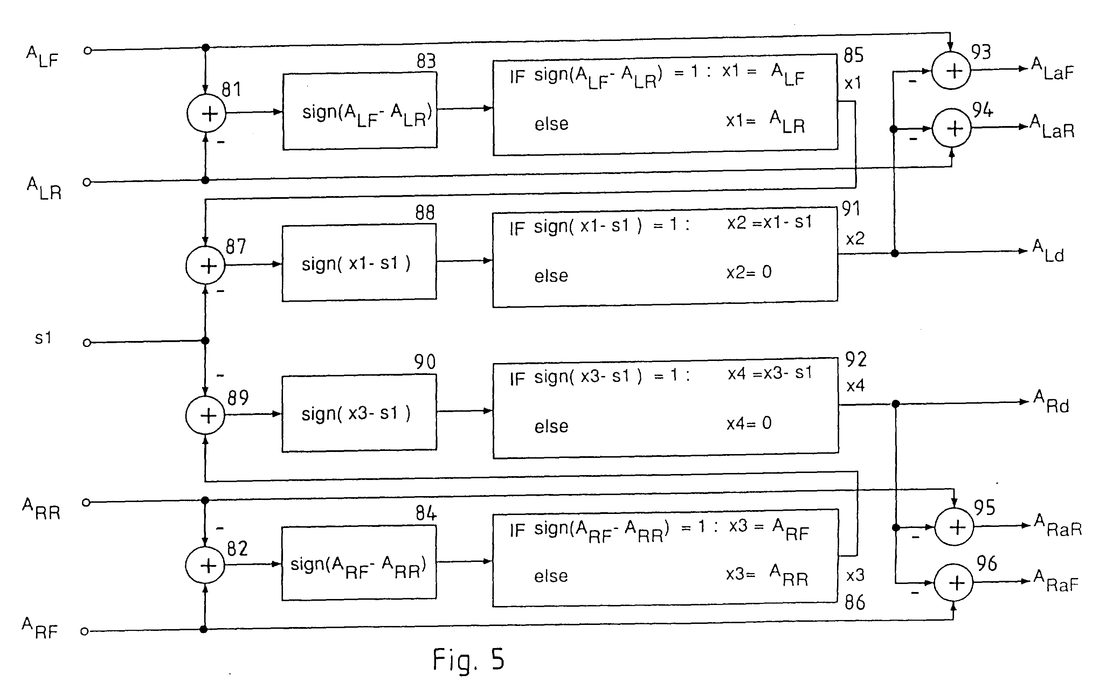

Sowohl für den linken Kanal als auch für den rechten Kanal (Fig. 5) erfolgt bei 81 bzw. 82 eine Differenzbildung mit anschließender Vorzeichenabfrage 83, 84. Bei 85, 86 wird der jeweils größere Dämpfungswert als Wert x1 bzw. x3 weitergeleitet und mit einem Schwellwert s1 bei 87, 88 bzw. 89, 90 verglichen. Dabei stellt der Schwellwert s1 die maximale Dämpfung des analogen Abschwächers dar. Die Differenz x1-S1 bzw. x3-S1 ist demnach der für das digitale Stellglied verbleibende Dämpfungswert. Die anschließende logische Auswertung 91, 92 dieser Differenz stellt sicher, daß der Wert für x2=A_{Ld} bzw. x4=A_{Rd} nicht negativ ist. Die Dämpfungswerte für die analogen Stellglieder werden mit Hilfe von Subtrahierern 93 bis 96 gebildet.

Fig. 6 stellt ebenfalls als Blockschaltbild ein Ausführungsbeispiel für den Lautstärkesteller 4 (Fig. 1) dar. Der linke Kanal für das Signal L_{KL} enthält einen Multiplizierer 101 als digitales Stellglied, einen Digital/Analog-Wandler 102 und ist im analogen Teil in einen vorderen Kanal und einen hinteren Kanal aufgespalten, der jeweils ein analoges Dämpfungsstellglied 103, 104 enthält. Von den Ausgängen 5, 6 sind die Signale LF und LR abnehmbar. Der rechte Kanal ist in gleicher Weise aufgebaut und enthält einen Multiplizierer 106, einen Digital/Analog-Wandler 107 und analoge Dämpfungsstellglieder 108, 109.

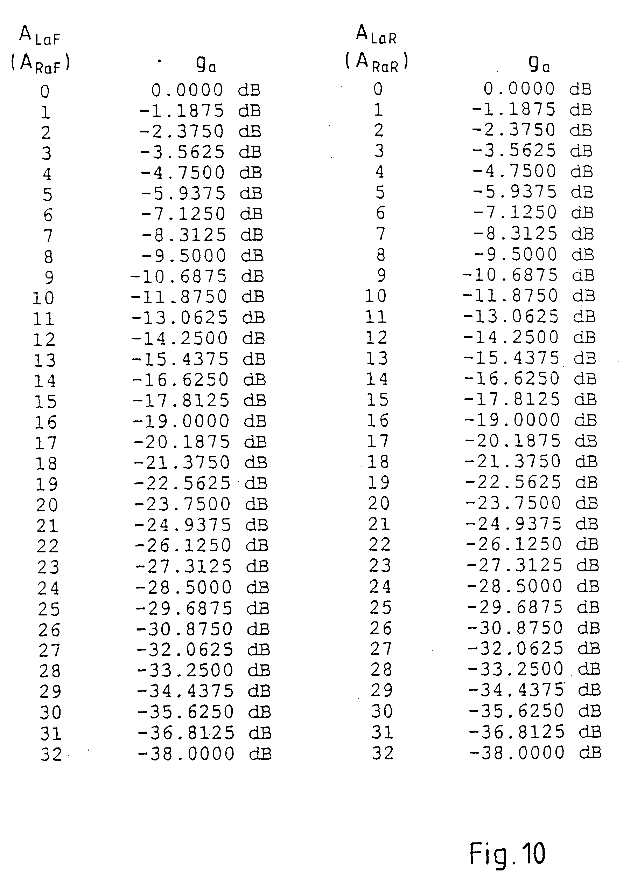

Die Dämpfungsstellglieder werden von an sich bekannten Netzwerken gebildet, deren Dämpfung mit Hilfe von Digitalsignalen steuerbar ist. Dazu werden die Stellgrößen A_{LaF}, A_{LaR}, A_{RaF} und A_{RaR} den analogen Dämpfungsstellgliedern 104, 103, 108, 109 zugeführt. Die Abhängigkeit des Übertragungsmaßes g ₐ von den Stellgrößen ist in Fig. 10 wiedergegeben.

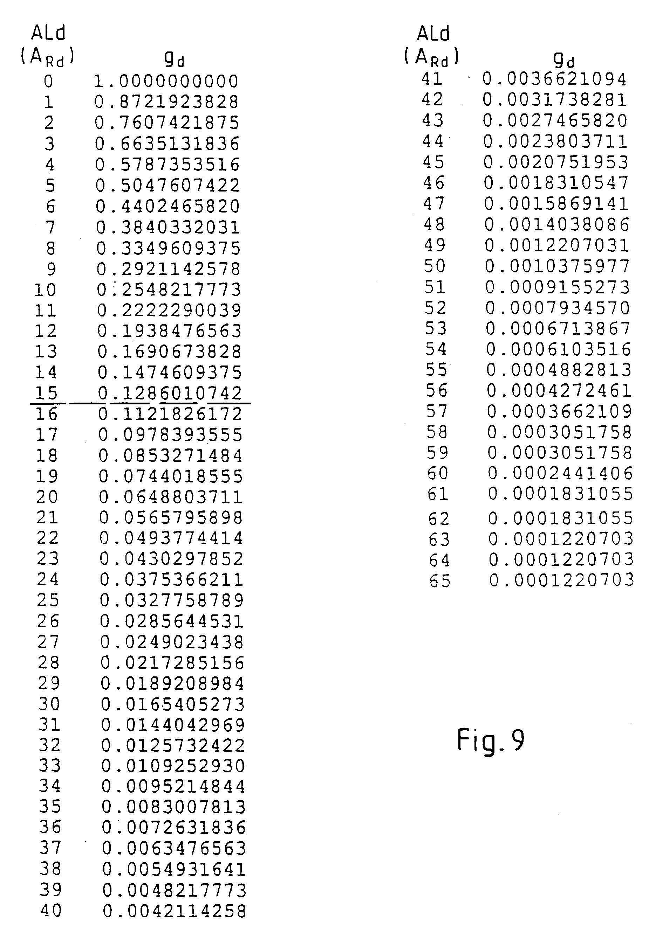

Die Stellgrößen A_{Ld} und A_{Rd} werden als Adressen jeweils einem Speicher 110, 111 zugeführt, der Faktoren für die Multiplizierer 101, 106, also das Übertragungsmaß g_{d} enthält. Ein Beispiel für den Inhalt dieser Tabellen ist in Fig. 9 wiedergegeben, wobei die Werte der Stellgröße A_{Ld} bzw. A_{Rd} als Dezimalzahlen dargestellt sind. Die gestrichelte waagerechte Linie zwischen dem Wert 15 und 16 deutet an, wieweit eine Verminderung des Pegels für mittlere Frequenzen infolge einer entsprechenden Tiefen- oder Höhenanhebung durchgeführt werden kann, die durch die Stellglieder wieder kompensiert wird.

Um eine Überschreitung des Adressenbereichs des Speichers 110, 111 zu verhindern, erfolgt eine logische Überwachung der Stellgrößen A_{Ld} und A_{Rd}. Dazu werden sie mit Hilfe jeweils eines Subtrahierers 112, 113 und einer Vorzeichenerkennung 114, 115 mit einem vorgegebenen Wert g1 verglichen. Solange die jeweilige Stellgröße kleiner als g1 ist, wird die Stellgröße von einer jeweiligen Logikschaltung 116, 117 weitergeleitet. Ist jedoch A_{Ld} bzw. A_{Rd} größer als g1, so wird der Maximalwert g1 als Adresse für den jeweiligen Speicher 110, 111 verwendet.

## Patentansprüche

1. Schaltungsanordnung zur digitalen Verarbeitung von Audiosignalen in einem Rundfunkempfänger, vorzugsweise einem Autoradio, wobei die Audiosignale einen Lautstärkesteller (4), dessen Übertragungsmaß mit zugeführten Stellgrößen steuerbar ist, und ein als Klangsteller ausgebildetes digitales Filter (3), dessen Frequenzgang über seine Koeffizienten steuerbar ist, durchlaufen, wcbei zur Bildung der Koeffizienten des digitalen Filters (3) weitere Stellgrößen zuführbar sind, die den Verlauf des Frequenzgangs bei hohen und bei tiefen Frequenzen gegenüber mittleren Frequenzen steuern, wobei im Falle eines Anhebens der hohen und/oder tiefen Frequenzen das Übertragungsmaß des Filters (3) bei mittleren Frequenzen entsprechend abgesenkt wird, und wobei eine die Absenkung Kennzeichnende Stellgröße dem Lautstärkesteller (4) zur Kompensation der Absenkung zugeführt ist.

2. Schaltungsanordnung nach Anspruch 1, dadurch gekennzeichnet, daß die zur Bildung der Koefffizienten zugeführten weiteren Stellgrößen Adressen von Speichern für die Koeffizienten bilden, und daß Multiplizierer (29 bis 32) vorgesehen sind, in denen mindestens ein Teil der aus den Speichern ausgelesenen Koeffizienten mit einer Steuergröße multipliziert wird, die von einer die Absenkung beschreibenden zugeführten Stellgröße abhängig ist.

3. Schaltungsanordnung nach Anspruch 2, dadurch gekennzeichnet, daß zur Absenkung bei einer Anhebung der hohen Frequenzen und bei einer Anhebung der tiefen Frequenzen je eine Stellgröße zuführbar ist, deren Summe die Stellgröße zur Kompensation der Absenkung bildet.

4. Schaltungsanordnung nach einem der vorhergehenden Ansprüche, dadurch gekennzeichnet, daß der Lautstärkesteller (4) mindestens ein Stellglied (101, 106) für digitale Signale, an das sich ein Digital/Analog-Wandler (102, 107) anschließt, und mindestens ein Stellglied (103, 104, 108, 109) für analoge Audiosignale aufweist und daß den Stellgliedern (101, 106, 103, 104, 108, 109) Stellgrößen derart zugeführt werden, daß das Stellglied (101, 106) für digitale Audiosignale möglichst bei einem maximalen Übertragungsmaß betrieben wird.

5. Schaltungsanordnung nach Anspruch 4, dadurch gekennzeichnet, daß zur Verarbeitung von Stereo-Audiosignalen Stellgrößen für die Lautstärke und die Balance zuführbar sind, daß die zugeführten Stellgrößen und eine weitere die Kompensation einer Absenkung der mittleren Frequenzen im Klangsteller (3) bewirkende weitere Stellgröße zur Bildung von jeweils den linken und den rechten Kanal betreffenden Stellgrößen überlagert werden und daß die Stellgrößen für den linken und den rechten Kanal anschließend jeweils in Stellgrößen für die Stellglieder (101, 106) für die digitalen Audiosignale und Stellgrößen für die Stellglieder (103, 104, 108, 109) für die analogen Audiosignale aufgespalten werden.

6. Schaltungsanordnung nach Anspruch 5, dadurch gekennzeichnet, daß ferner für den linken und den rechten Kanal jeweils zwei Stellglieder (103, 104, 108, 109) parallel angeordnet sind, wobei das Verhältnis zwischen dem Übertragungsmaß dieser Stellglieder durch eine weitere zugeführte Stellgröße, die den Stellgrößen überlagert wird, steuerbar ist.

7. Schaltungsanordnung nach einem der Ansprüche 4 bis 6, dadurch gekennzeichnet, daß die Stellglieder eine exponentielle Charakteristik zwischen dem Übertragungsmaß und dem Zahlenwert der zugeführten Stellgröße aufweisen und daß die Überlagerung der Stellgrößen durch Addition erfolgt.

## Claims

1. Circuit arrangement for digital processing of audio signals in a broadcast radio receiver, preferably a car radio, in which case the audio signals pass through a volume controller (4), whose transmission level can be controlled by supplied manipulated variables, and a digital filter (3) which is designed as a toner controller and whose frequency response can be controlled via its coefficients, in which case further manipulated variables can be supplied in order to form the coefficients of the digital filter (3), which further manipulated variables control the profile of the frequency response at high frequencies and at low frequencies with respect to medium frequencies, in which case the transmission level of the filter (3) at medium frequencies is correspondingly reduced when that for high and/or low frequencies is raised, and in which case a manipulated variable which characterizes the reduction is supplied to the volume controller (4) in order to compensate for the reduction.

2. Circuit arrangement according to Claim 1, characterized in that the further manipulated variables which are supplied to form the coefficients form addresses of memories for the coefficients, and in that multipliers (29 to 32) are provided in which at least some of the coefficients which are read from the memories are multiplied by a control variable which is dependent on a supplied manipulated variable which describes the reduction.

3. Circuit arrangement according to Claim 2, characterized in that one manipulated variable can in each case be supplied for the reduction when the high frequencies are raised and when the low frequencies are raised, the sum of which manipulated variables forms the manipulated variable to compensate for the reduction.

4. Circuit arrangement according to one of the preceding claims, characterized in that the volume controller (4) has at least one control element (101, 106) for digital signals, to which a digital/analogue converter (102, 107) is connected, and at least one control element (103, 104, 108, 109) for analogue audio signals, and in that the control elements (101, 106, 103, 104, 108, 109) are supplied with manipulated variables in such a manner that the control element (101, 106) for digital audio signals is operated as far as possible at a maximum transmission level.

5. Circuit arrangement according to Claim 4, characterized in that manipulated variables for the volume and the balance can be supplied for the processing of stereo audio signals, in that the supplied manipulated variables and a further manipulated variable which produces the compensation for any reduction in the medium frequencies in the tone controller (3) respectively have superimposed on them manipulated variables which relate to the left-hand channel and to the right-hand channel, and in that the manipulated variables for the left-hand channel and for the right-hand channel are then each split into manipulated variables for the control elements (101, 106) for the digital audio signals, and manipulated variables for the control elements (103, 104, 108, 109) for the analogue audio signals.

6. Circuit arrangement according to Claim 5, characterized in that, furthermore, two control elements (103, 104, 108, 109) are respectively arranged in parallel for the left-hand channel and for the right-hand channel, in which case the ratio between the transmission level of these control elements can be controlled by a further supplied manipulated variable, which is superimposed on the manipulated variables.

7. Circuit arrangement according to one of Claims 4 to 6, characterized in that the control elements have an exponential characteristic between the transmission level and the numeric value of the supplied manipulated variable, and in that the manipulated variables are superimposed by addition.

## Revendications

1. Circuit de traitement numérique des signaux audio d'un récepteur radio, notamment d'un autoradio, selon lequel les signaux audio traversent un organe de réglage de volume (4) dont le degré de transmission se commande par l'envoi de grandeurs de réglage, et un filtre numérique (3) réalisé en forme d'organe de réglage de son, dont la réponse en fréquence se commande par ses coefficients, et, pour former les coefficients du filtre numérique (3), on applique d'autres grandeurs de réglage qui commandent le profil de la réponse en fréquence aux fréquences hautes et aux fréquences basses par rapport aux fréquences moyennes, et dans le cas d'une accentuation des fréquences hautes et/ou des fréquences basses, le degré de transmission du filtre (3) est abaissé d'autant pour les fréquences moyennes et une grandeur de réglage caractérisant l'abaissement, est appliquée à l'organe de réglage de volume (4) pour compenser l'abaissement.

2. Circuit selon la revendication 1,
caractérisé en ce que
• les autres grandeurs de réglage, appliquées pour former les coefficients, sont les adresses de mémoire pour les coefficients,
• le circuit comportant des multiplicateurs (29-32) dans lesquels au moins une partie des coefficients lus dans les mémoires sont multipliés par une grandeur de commande qui dépend d'une grandeur de réglage décrivant l'abaissement.

3. Circuit selon la revendication 2,
caractérisé en ce que
pour l'abaissement en cas d'accentuation des fréquences élevées et en cas d'accentuation des fréquences basses, on fournit chaque fois une grandeur de réglage, et la somme de ces grandeurs forme la grandeur de réglage pour compenser l'abaissement.

4. Circuit selon l'une quelconque des revendications précédentes,
caractérisé en ce que
• l'organe de réglage de volume (4) comporte au moins un élément de réglage (101, 106) pour les signaux numériques suivi d'un convertisseur numérique/analogique (102, 107) et au moins un élément de réglage (103, 104, 108, 109) pour les signaux audio analogiques, et
• les éléments de réglage (101, 106, 103, 104, 108, 109) reçoivent des grandeurs de réglage pour que l'élément de réglage (101, 106) des signaux audio numériques fonctionne si possible avec un degré de transmission maximum.

5. Circuit selon la revendication 4,
caractérisé en ce que
• pour le traitement des signaux audio stéréophoniques, il reçoit des grandeurs de réglage pour le volume et la balance,
• les grandeurs de réglage fournies et une autre grandeur de réglage pour la compensation, produisant un abaissement des fréquences moyennes dans l'organe de réglage de son (3), sont combinées pour former chaque fois les grandeurs de réglage du canal gauche et celles du canal droit,
• les grandeurs de réglage du canal gauche et celles du canal droit étant réparties alors chaque fois en grandeurs de réglage pour les éléments de réglage (101, 106) pour les signaux audio numériques, et en grandeurs de réglage pour les éléments de réglage (103, 104, 108, 109) des signaux audio analogiques.

6. Circuit selon la revendication 5,
caractérisé par
deux éléments de réglage (103, 104, 108, 109) prévus en parallèle pour chaque fois le canal gauche et le canal droit, le rapport entre le degré de transmission de ces éléments de réglage se commandant par une autre grandeur de réglage, fournie, que l'on combine aux grandeurs de réglage.

7. Circuit selon l'une des revendications 4 à 6,
caractérisé en ce que
les éléments de réglage présentent une caractéristique exponentielle entre le degré de transmission et la valeur numérique des grandeurs de réglage appliquées, et la combinaison de ces grandeurs de réglage se fait par addition.
